# FASCICULE DE BREVET EUROPEEN

(11) **EP 4 078 658 B1**
(45) Date de publication et mention de la délivrance du brevet: **25.10.2023**
(21) Numéro de dépôt: 20824606.6
(22) Date de dépôt: 27.11.2020
(51) Int. Cl.: H01L 21/306

(54) **PROCEDE DE GRAVURE DE SUBSTRATS COMPORTANT UNE COUCHE MINCE SUPERFICIELLE, POUR AMELIORER L'UNIFORMITE D'EPAISSEUR DE LADITE COUCHE**
VERFAHREN ZUM ÄTZEN VON SUBSTRATEN MIT EINER DÜNNEN OBERFLÄCHENSCHICHT ZUR VERBESSERUNG DER GLEICHMÄSSIGKEIT DER DICKE DER SCHICHT
METHOD FOR ETCHING SUBSTRATES COMPRISING A THIN SURFACE LAYER, FOR IMPROVING THE UNIFORMITY OF THICKNESS OF SAID LAYER

(30) Priorité: 17.12.2019 FR 1914638
(43) Date de publication de la demande: 26.10.2022
(73) Titulaire: SOITEC, 38190 Bernin (FR)
(72) Inventeur: VIRAVAUX, Laurent, 38700 CORENC (FR); CARTON, Sébastien, 38530 PONTCHARRA (FR); ROS, Onintza, 38000 GRENOBLE (FR)
(74) Mandataire: IP Trust
(86) Numéro de dépôt international: PCT/FR2020/052205
(87) Numéro de publication internationale: WO 2021/123529

(56) Documents cités:
- EP-A2- 2 192 610
- US-A- 5 788 800

## Description

### DOMAINE DE L'INVENTION

La présente invention concerne le domaine de la microélectronique, optoélectronique, photonique, etc. Elle concerne en particulier un procédé de gravure de substrats utilisant un équipement de nettoyage multi-plaques à bains chimiques ; l'invention est particulièrement adaptée aux substrats SOI (« Silicon on Insulator », soit silicium sur isolant) comportant une très fine couche superficielle de silicium.

### ARRIERE PLAN TECHNOLOGIQUE DE L'INVENTION

De plus en plus d'applications basées sur des substrats SOI requièrent de très bonnes uniformités d'épaisseur de la couche mince superficielle de silicium (destinée à accueillir des composants ou à en être le support). Par exemple, dans les applications digitales, la couche mince des substrats FDSOI (« Fully depleted SOI », soit SOI totalement déserté) doit présenter de très faibles variations d'épaisseur car ces dernières impactent la tension de seuil des transistors élaborés sur ladite couche mince. Dans les applications photoniques, les performances des dispositifs de type filtres ou modulateurs sont également fortement influencées par les non-uniformités d'épaisseur de la couche mince du substrat SOI.

Les spécifications en termes d'épaisseur et d'uniformité deviennent donc très agressives : on attend pour des couches d'épaisseurs typiquement inférieures à 50nm, des non-uniformités sur plaque (WiW pour « within wafer ») et entre plaques (WtW pour « wafer to wafer ») inférieures à quelques angströms, typiquement inférieures à 4A. (Dans la présente description, on pourra utiliser l'angström, unité A, qui équivaut à 0.1 nanomètre). De telles uniformités sont difficiles à atteindre car la succession d'étapes de fabrication du substrat SOI empile les contributions à la non-uniformité de la couche mince.

Une solution connue pour corriger les non-uniformités d'épaisseur de la couche mince est de réaliser une gravure localisée de ladite couche, par des procédés de gravure plasma (« plasma etch ») comme décrit par exemple dans le document US20140234992, ou par des procédés de gravure par faisceau d'ions (« cluster ion beam etch ») comme décrit notamment dans le document WO2013003745. Ce type de solutions présente néanmoins un inconvénient : la gravure de la surface de la couche mince crée une zone superficielle de silicium amorphe susceptible de générer des problèmes électriques et qui doit donc être retirée. Le retrait de la zone amorphe mène à une augmentation de la rugosité de surface, laquelle dégrade les performances du dispositif élaboré sur la couche mince.

Le document WO2004015759 propose une solution alternative, mettant en oeuvre une oxydation thermique sacrificielle localisée, consommant ponctuellement une épaisseur plus ou moins importante de la couche mince, de manière à corriger ses non-uniformités d'épaisseur. L'inconvénient de cette approche est qu'un gradient de température local n'est pas facile à introduire dans une couche de silicium : la résolution de la correction de non-uniformités peut donc être limitée.

Les documents US 5 788 800 A et EP 2 192 610 A décrivent encore d'autres techniques de compensation des variations d'épaisseur d'une couche sur un substrat.

### OBJET DE L'INVENTION

La présente invention concerne une solution alternative à celles de l'état de la technique, et vise à remédier à tout ou partie des inconvénients précités. Elle concerne en particulier un procédé de préparation d'une couche mince pour atteindre une uniformité d'épaisseur améliorée de ladite couche, procédé dont la mise en oeuvre est simple et reproductible. Un tel procédé de préparation peut être avantageusement implémenté pour la fabrication de structures SOI avec une couche superficielle de silicium très fine.

### BREVE DESCRIPTION DE L'INVENTION

L'invention concerne un procédé de gravure d'une surface principale d'un substrat comprenant une couche mince superficielle, la surface principale correspondant à la face libre de ladite couche mince ; le procédé comprend l'immersion du substrat dans un bain de gravure de manière à exposer la surface principale à un agent de gravure, le substrat étant orienté vis-à-vis du bain de sorte que :
- lors de son introduction dans le bain, la surface principale soit immergée progressivement d'un point initial d'introduction à un point final d'introduction, avec une vitesse d'introduction, et
- lors de sa sortie du bain, la surface principale émerge progressivement d'un point initial de sortie à un point final de sortie, avec une vitesse de sortie.

Le procédé est remarquable en ce que :
- la vitesse d'introduction est choisie de manière à graver la surface principale selon un premier profil non uniforme entre le point initial d'introduction et le point final d'introduction, et/ou
- la vitesse de sortie est choisie de manière à graver la surface principale selon un deuxième profil non uniforme entre le point initial de sortie et le point final de sortie,
pour compenser des non-uniformités d'épaisseur de la couche mince.

Selon d'autres caractéristiques avantageuses et non limitatives de l'invention, prises seules ou selon toute combinaison techniquement réalisable :
- le premier profil de gravure définit une variation d'épaisseur gravée sur la surface principale, entre le point initial d'introduction et le point final d'introduction, supérieure ou égale à 0,15 nm, voire supérieure ou égale 0,2 nm, et/ou
- le deuxième profil de gravure définit une variation d'épaisseur gravée sur la surface principale, entre le point initial de sortie et le point final de sortie, supérieure ou égale à 0,15 nm, voire supérieure ou égale à 0,2 nm ;
- le point initial d'introduction correspond au point final de sortie, et le point final d'introduction correspond au point initial de sortie ;
- la vitesse d'introduction et/ou la vitesse de sortie est(sont) comprise(s) entre 25cm/s et 0,1cm/s, préférentiellement entre 10cm/s et 0,5cm/s ;
- la vitesse d'introduction et/ou la vitesse de sortie est(sont) non constante(s) respectivement lors de l'introduction dans le bain et de la sortie hors du bain, du substrat ;
- le bain de gravure contient une solution SC1 (« standard clean 1 »), présentant les proportions 1/2/20 respectivement pour l'ammoniac, le peroxyde d'hydrogène et l'eau déionisée ;
- le substrat est un substrat SOI dont la couche mince superficielle présente une épaisseur inférieure à 50nm et est disposée sur une couche isolante, laquelle est disposée sur un substrat support en silicium ;
- la couche mince est en silicium monocristallin.

### BREVE DESCRIPTION DES FIGURES

D'autres caractéristiques et avantages de l'invention ressortiront de la description détaillée de l'invention qui va suivre en référence aux figures annexées sur lesquelles :
- La figure 1 présente des substrats susceptibles d'être traités avec le procédé de fabrication conforme à l'invention ;
- La figure 2 présente des étapes d'un procédé de transfert d'une couche mince sur un substrat support, connu de l'état de la technique ;
- La figure 3 présente une cartographie de la non uniformité d'épaisseur de la couche mince d'un substrat susceptible d'être traité avec le procédé de fabrication conforme à l'invention ;
- Les figures 4a et 4b présentent un schéma de principe d'un substrat, respectivement, lors de son introduction dans un bain de gravure et lors de sa sortie hors du bain de gravure, dans un procédé de gravure conforme à la présente invention ;
- La figure 5a présente une cartographie d'un profil non uniforme de gravure obtenu à partir du procédé de gravure conforme à la présente invention, sur la couche mince d'un substrat ;
- La figure 5b présente le gradient de gravure normalisé sur des profils Nord/Sud selon des droites numérotées de 1 à 5, obtenu à partir du procédé de gravure conforme à la présente invention, sur la couche mince d'un substrat ;
- La figure 6 présente un diagramme en boîte illustrant le gradient d'épaisseur gravée dans un exemple de profils non uniformes de gravure obtenus sur une pluralité de substrats traités avec le procédé de gravure conforme à la présente invention ; le diagramme en boîte illustre également le gradient d'épaisseur gravée pour une utilisation conventionnelle du bain de gravure.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

La présente invention concerne un procédé de gravure d'une surface principale la d'un substrat 1. La surface principale la est en particulier la face avant du substrat 1, c'est-à-dire celle dont les propriétés physiques (rugosité, uniformité, propreté...) sont étroitement surveillées en vue de l'élaboration de composants.

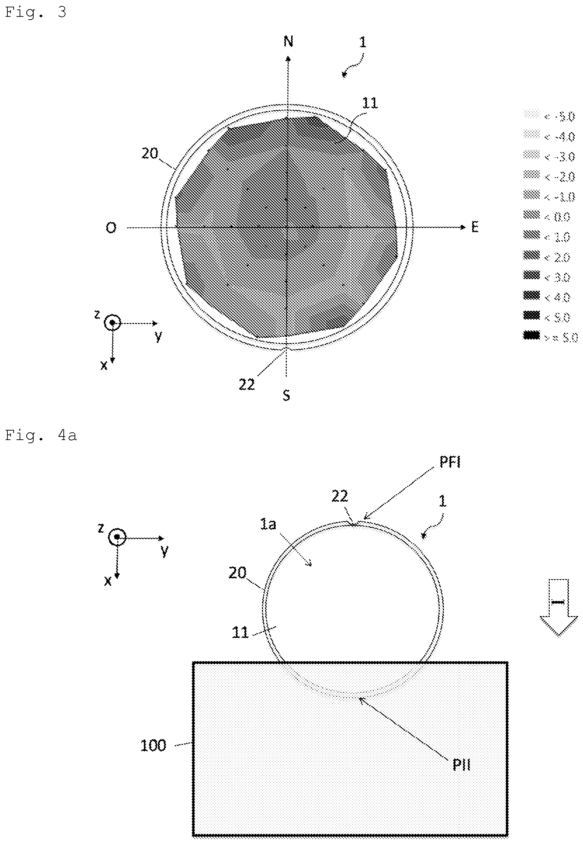

Le procédé de gravure est de type gravure humide, il comprend l'immersion du substrat 1 dans un bain liquide de gravure 100 (figure 4a) de manière à exposer la surface principale la à un agent de gravure.

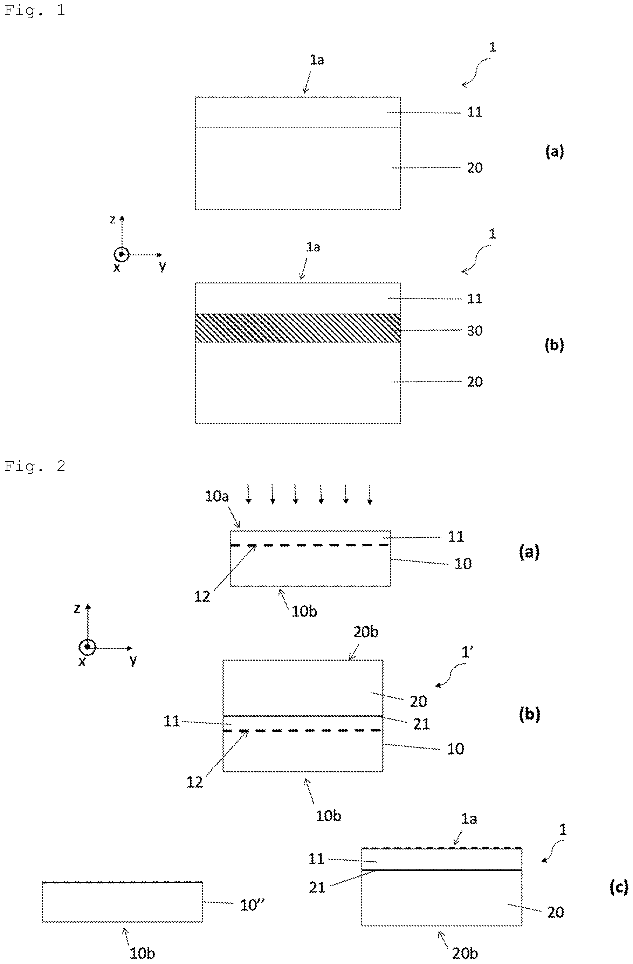

La présente invention va être décrite dans le cas particulier d'un substrat 1 comprenant une couche mince superficielle 11 disposé sur un substrat support 20 (figure 1). La surface principale la correspond dans ce cas à la face libre de ladite couche mince 11 sur laquelle des composants sont destinés à être fabriqués. La couche mince 11 est avantageusement en matériau monocristallin avec un très faible taux de défectivité.

Comme cela est bien connu en soi, le substrat 1 peut être formé de la couche mince 11 directement disposée sur le substrat support 20 (figure 1 (a)), ou il peut comprendre, entre la couche mince 11 et le substrat support 20, une couche intermédiaire 30 (figure 1 (b)). Cette couche intermédiaire 30 peut être isolante comme cela est le cas pour un substrat 1 de type SOI. Alternativement, elle peut être semi-conductrice ou conductrice, selon les propriétés visées du substrat 1.

Il existe plusieurs méthodes connues de report d'une couche mince 11 monocristalline sur un substrat support 20, parmi lesquelles le procédé Smart Cut^{™}, basé sur une implantation d'espèces légères pour créer un plan fragile enterré 12 dans un substrat donneur 10 (figure 2 (a)). Ce procédé est également basé sur un collage direct par adhésion moléculaire pour former une interface de collage 21 entre les deux substrats 10,20 et les assembler (figure 2 (b)).

Les substrats donneur 10 et support 20 se présentent préférentiellement chacun sous la forme d'une plaquette circulaire de diamètre 200mm ou 300mm, voire 450mm, et d'épaisseur typiquement comprise entre 500 et 900 microns.

Bien-sûr, l'un des deux (ou les deux) substrats 10,20 peut comporter tout ou partie d'une couche intermédiaire 30 au niveau de sa face à assembler, lorsqu'une telle couche 30 est requise dans l'empilement final du substrat 1. La séparation le long du plan fragile enterré 12 permet le transfert d'une couche mince 11 issue du substrat donneur 10 sur le substrat support 20 (figure 2 (c)). Juste après séparation, la surface libre de la couche mince 11 présente un niveau de rugosité important (de l'ordre de 40 à 80 A, par mesure au microscope à force atomique, sur scan de 30 x 30 microns). Parmi les techniques de finition de surface, on peut notamment mettre en oeuvre des traitements thermiques d'oxydation sacrificielle, de gravure et/ou de reconstruction de surface sous atmosphère neutre ou réductrice.

Ces traitements sont réalisés en général à hautes températures, dépendamment du matériau constituant la couche mince 11. Par exemple, pour une couche en silicium, une oxydation peut être réalisée entre 750°C et 1100°C environ, et un lissage sous atmosphère neutre ou réductrice entre 950°C et 1250°C.

A l'issue de ces traitements de finition, on obtient un substrat 1 pourvu de sa couche mince 11 superficielle. Comme évoqué en introduction, les spécifications en termes d'uniformité d'épaisseur de ladite couche 11 deviennent de plus en plus serrées, d'autant plus que son épaisseur diminue.

La demanderesse a identifié que la non-uniformité d'épaisseur de la couche mince 11 obtenue par le procédé Smart Cut, tout particulièrement dans le cas de couches 11 présentant de très faibles épaisseurs inférieures à 50nm, voire inférieures à 20nm, est notamment liée à deux contributions de symétrie non concentrique.

La première contribution à la non-uniformité de la couche mince 11 vient des variabilités naturelles des multiples étapes successives opérées pour la fabrication du substrat 1, et induit des variations d'épaisseur de la couche 11 non prévisibles (« random »), qu'il est donc difficile d'éliminer.

La deuxième contribution vient des étapes de fabrication présentant une symétrie non concentrique : par exemple, l'implantation ionique, la séparation au niveau du plan fragile enterré et/ou les traitements thermiques par lots qui font intervenir des supports maintenant localement les substrats 1. Cette contribution génère des non-uniformités d'épaisseur de la couche mince 11 plus ou moins marquées entre des points cardinaux N,S,E,O du substrat 1. Par exemple, sur la figure 3, une non-uniformité d'épaisseur de l'ordre de 0,6 nm est visible entre les deux points cardinaux N (Nord) et S (Sud), selon la direction Nord-Sud. Notons que l'échelle de valeurs sur la figure 3 est en Angström. La couche mince 11 est plus fine à proximité du point S et plus épaisse à proximité du point N. Et ce profil de non-uniformité se répète sensiblement le long de toutes les lignes imaginaires que l'on tracerait parallèles à la direction Nord-Sud. En d'autres termes, la région Nord (région à proximité du point N) de la couche mince 11 apparaît plus épaisse que la région Sud (à proximité du point S).

Notons que la cartographie de non-uniformité d'épaisseur de la figure 3 est établie à partir de la mesure d'épaisseur par ellipsométrie ou réflectométrie de la couche mince 11. Dans cet exemple, la couche mince 11 est en silicium et présente une épaisseur moyenne de 12 nm.

Les étapes précitées, génératrices de non-uniformités à symétrie non concentrique, sont réalisées dans des équipements multi-plaques, simultanément sur des lots de plusieurs dizaines, voire plusieurs centaines de substrats 1. Pour garantir une traçabilité et une reproductibilité des performances aux différentes étapes, sur les différents lots de substrats 1, il est habituel de positionner tous les substrats 1 dans une même position, identifiable par la présence d'un méplat ou d'une encoche 22 (appelée « notch » selon la terminologie anglo-saxonne) aménagé(e) sur la tranche de chaque substrat 1. En pratique, l'encoche sera placée en haut (point cardinal Nord) ou en bas (point cardinal Sud - comme dans l'exemple de la figure 3) ou à un angle défini entre deux des points cardinaux. Ainsi, le profil de non-uniformité apparaît de façon relativement reproductible sur l'ensemble des substrats 1 de lots traités simultanément ou successivement dans les différentes étapes.

Le procédé de gravure selon l'invention adresse tout particulièrement la deuxième contribution énoncée de non uniformité d'épaisseur.

Comme précédemment indiqué, le procédé de gravure vise à exposer la surface principale 1a du substrat 1 à un agent de gravure par immersion dans un bain 100 contenant une solution liquide.

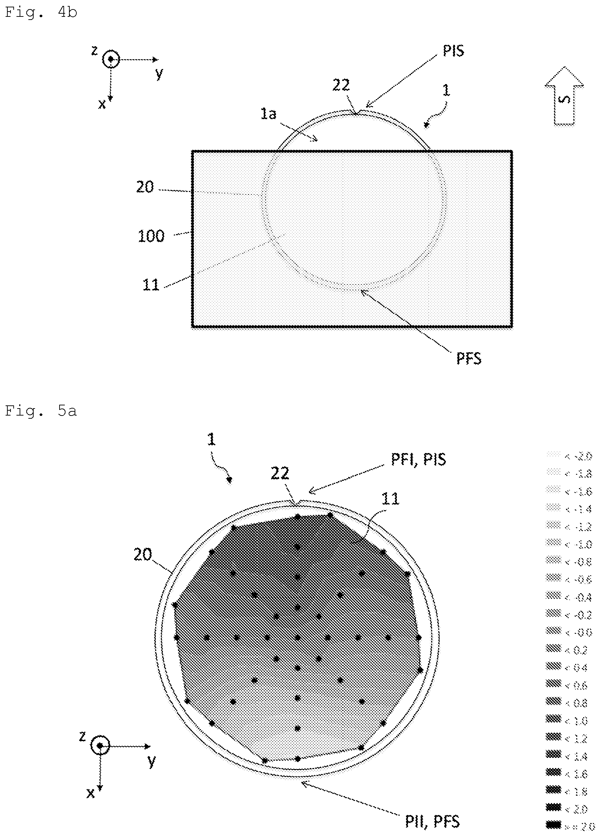

Le substrat 1 est orienté vis-à-vis du bain 100 de gravure de manière à ce que, lors de son introduction I dans le bain 100, la surface principale 1a soit immergée progressivement d'un point initial d'introduction PII jusqu'à un point final d'introduction PFI traduisant l'immersion totale du substrat 1 (figure 4a). En d'autres termes, la surface principale 1a forme un angle non nul avec la surface de la solution contenue dans le bain 100. Habituellement, cet angle est de l'ordre de 90°. Lors de la sortie S du bain 100, la surface principale 1a émerge progressivement d'un point initial de sortie PIS jusqu'à un point final de sortie PFS traduisant la sortie totale du substrat 1 (figure 4b).

Selon le procédé de gravure de l'invention, la vitesse d'introduction du substrat 1 dans le bain 100 et/ou la vitesse de sortie du substrat 1 hors du bain 100 est (sont) choisie (s) de manière à générer un profil non-uniforme de gravure sur la surface principale 1a.

Plus particulièrement, la vitesse d'introduction peut être choisie de manière à graver la surface principale 1a selon un premier profil non-uniforme entre le point initial d'introduction PII et le point final d'introduction PFI. Alternativement ou cumulativement, la vitesse de sortie peut être choisie de manière à graver la surface principale 1a selon un deuxième profil non-uniforme entre le point initial de sortie PIS et le point final de sortie PFS.

Avantageusement, le premier profil de gravure définit une variation (ou gradient) d'épaisseur gravée sur la surface principale 1a, entre le point initial d'introduction PII et le point final d'introduction PFI, supérieure ou égale à 0,15 nm, voire supérieure ou égale 0,2 nm.

De même, le deuxième profil de gravure définit préférentiellement une variation (ou gradient) d'épaisseur gravée sur la surface principale 1a, entre le point initial de sortie PIS et le point final de sortie PFS, supérieure ou égale à 0,15 nm, voire supérieure ou égale à 0,2 nm.

Le point initial d'introduction PII pourra correspondre au point final de sortie PFS, et le point final d'introduction PFI pourra correspondre au point initial de sortie PIS.

Optionnellement, pour ajuster plus finement les profils de gravure non-uniformes à un type de non-uniformité d'épaisseur particulier de la couche mince 11, une rotation d'un angle défini pourra être appliqué au substrat 1, de manière à ce que les points d'introduction PII,PFI et les points de sortie PIS,PFS soient différents entre eux.

Selon encore une autre option, le procédé de gravure peut être appliqué plusieurs fois consécutives, en opérant une rotation du substrat 1 entre chacune des itérations, pour ajuster finement les profils de gravure non-uniformes de chaque itération à un type de non-uniformité d'épaisseur particulier de la couche mince 11.

Les vitesses d'introduction et de sortie des substrats 1 dans un équipement de nettoyage ou de gravure multi-plaques en bains chimiques liquides sont conventionnellement rapides. Par exemple, de l'ordre de 30 cm/s pour des substrats de 300mm de diamètre. Chaque substrat 1 entre donc dans le bain en moins de 2 secondes, de manière à obtenir la meilleure uniformité de traitement possible au cours de l'étape.

A l'inverse de ce principe, dans le procédé de gravure de l'invention, au moins une vitesse parmi la vitesse d'introduction et la vitesse de sortie du substrat 1 (ou des substrats 1) est avantageusement réduite : elle peut être comprise entre 25 cm/s et 0,1 cm/s, voire en particulier entre 10cm/s et 0,5cm/s. Comme cela va être plus particulièrement expliqué dans un mode de réalisation préféré ci-dessous, la réduction des vitesses d'introduction dans le bain 100 et/ou de sortie hors du bain 100, du substrat 1, permet de générer des profils de gravure non-uniformes et de compenser les non-uniformités d'épaisseur de la couche mince 11 selon la deuxième contribution précitée.

La vitesse d'introduction et/ou la vitesse de sortie pourra(ont) également être choisie(s) non constante(s), pour compenser des profils de non-uniformité non linéaires sur le diamètre du substrat 1.

Selon un mode de réalisation préféré, la couche mince 11 est en silicium monocristallin et la solution du bain de gravure 100 est une solution de SC1 (« standard clean 1 »), à base d'eau déionisée, d'ammoniac (NH3) et de peroxyde d'hydrogène (H202). La solution SC1, habituellement utilisée pour le nettoyage de plaques de silicium, est particulièrement efficace pour éliminer les contaminations particulaires des surfaces traitées.

Le procédé de gravure selon l'invention prévoit par exemple d'utiliser une solution SC1 dont la vitesse de gravure de la couche mince 11 en silicium est de l'ordre de 0,5nm/min. Les ratios volumiques respectifs des trois composés NH3/H2O2/H2O de la solution sont alors 1/2/20, et la température du bain est de 70°C. Une agitation de la solution par méga-sons est également privilégiée.

A titre d'exemple, la figure 5a présente un profil non-uniforme de gravure obtenu sur la couche mince 11 d'un substrat 1 de 300mm de diamètre, dans un bain de gravure SC1 tel que ci-dessus, avec une vitesse d'introduction du substrat 1 dans le bain, de 23cm/s, un temps de résidence dans le bain de 90s, et une vitesse de sortie de 0,67cm/s (soit 45s entre l'émergence du point initial de sortie PIS et l'émergence du point final de sortie PFS). Dans cet exemple, le point initial d'introduction PII est confondu avec le point final de sortie PFS, et le point final d'introduction PFI est confondu avec le point initial de sortie PIS ; l'encoche 22 est placée au point final d'introduction PFI (également point initial de sortie PIS).

La vitesse de sortie a été plus particulièrement diminuée, c'est donc au cours de sa sortie du bain que le profil de gravure non-uniforme de la figure 5a (ou deuxième profil de gravure non-uniforme tel qu'évoqué précédemment) s'est essentiellement formé. Le gradient d'épaisseur gravée entre les deux points d'introduction PII,PFI (ou entre les deux points de sortie PIS, PFS) est de l'ordre de 3 A : l'épaisseur gravée est plus importante au point initial d'introduction PII (ou point final de sortie PFS) et moindre au point final d'introduction PFI (ou point initial de sortie PIS).

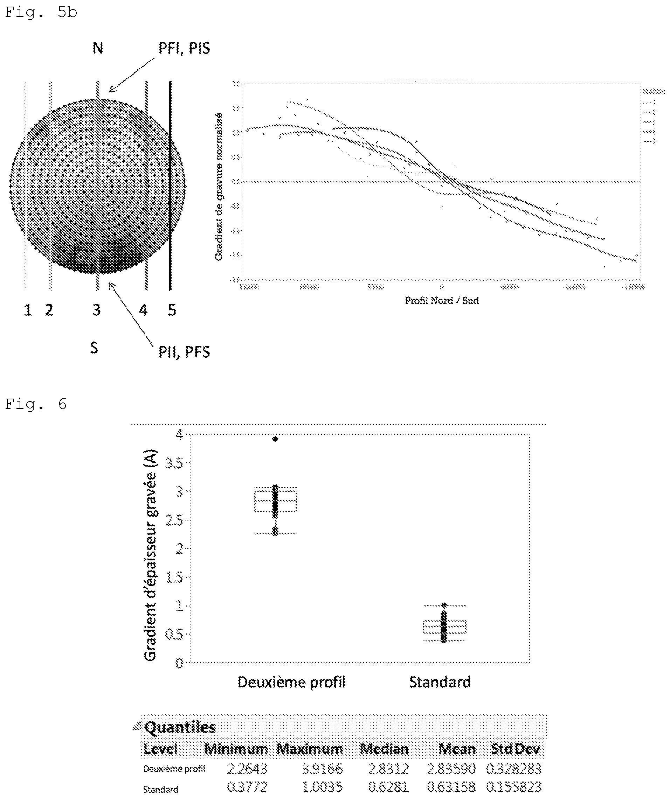

La figure 5b illustre le gradient de gravure normalisé sur des profils Nord/Sud selon des droites numérotées de 1 à 5, sur un substrat 1 ayant subi le procédé de gravure selon l'exemple précité. On retrouve que le gradient d'épaisseur gravée entre les deux points d'introduction PII,PFI (ou entre les deux points de sortie PIS, PFS) est de l'ordre de 3 A.

La reproductibilité de ce deuxième profil a été vérifiée sur une pluralité de substrats 1, traités simultanément dans le bain de gravure 100. Le graphe de la figure 6 montre les résultats des gradients d'épaisseur (en angströms) du deuxième profil sous forme de diagramme en boîte (« boxplot » selon la terminologie anglo-saxonne), comparés aux résultats obtenus lorsque les vitesses d'introduction et de sortie sont standard, c'est-à-dire supérieures à 25cm/s.

On retrouve bien statistiquement un gradient de gravure sur le substrat 1, entre les deux points d'introduction PII,PFI, égal en moyenne à 2,8 A (« mean » sur la figure 6), avec un écart-type (« std Dev » sur la figure 6) de l'ordre de 0,3 A.

L'application du deuxième profil de gravure non uniforme au substrat 1 particulier présentant une non-uniformité d'épaisseur telle que celle illustrée sur la figure 3, en prenant soin de placer l'encoche 22 au point final d'introduction PFI (et au point initial de sortie PIS) permet d'améliorer l'uniformité de la couche mince 11. En effet, le deuxième profil va permettre d'amincir davantage la région Nord dudit substrat 1 (initialement la plus épaisse) par rapport à sa région Sud (initialement la plus fine). La non-uniformité initiale de la couche mince 11, de l'ordre de 0,6 nm passe ainsi à moins de 0,4 nm, grâce au procédé de gravure selon l'invention.

Notons que la vitesse d'introduction aurait également pu être limitée entre 25 cm/s et 0,1 cm/s, pour ajuster plus finement l'enlèvement différentiel entre les deux points extrêmes d'introduction ou de sortie.

Le procédé de gravure selon ce mode de réalisation préféré peut être aisément intégré à une séquence de nettoyage sur un équipement multi-plaques de nettoyage par bains chimiques (« wet bench » selon la terminologie anglo-saxonne). Par exemple, il pourra être intégré dans une séquence du type Ozone / SC1 / SC2, en remplaçant l'étape SC1 ou en s'intercalant entre l'étape Ozone et l'étape SC1. L'intégration aisée du procédé de gravure dans une séquence de nettoyage est particulièrement avantageuse car les temps de rinçage et de chargement des lots de substrats 1 sont mutualisés et non multipliés par la séparation des étapes.

Le procédé de gravure selon la présente invention est particulièrement adapté pour corriger les non-uniformités de symétrie non concentrique de la couche mince 11 superficielle d'un substrat 1 de type SOI, ladite couche mince 11 et la couche isolante sous-jacente 30 présentant une épaisseur inférieure à 50 nm.

Bien entendu, l'invention n'est pas limitée aux modes de réalisation et aux exemples décrits, et on peut y apporter des variantes de réalisation sans sortir du cadre de l'invention tel que défini par les revendications.

Même si l'invention a été particulièrement décrite et illustrée en référence au mode de réalisation préféré, on peut bien sûr transposer la présente invention à une couche mince 11 en un matériau autre que le silicium monocristallin (par exemple en oxyde de silicium, etc), et mettre en oeuvre une solution du bain de gravure autre que le SC1 (par exemple, l'acide fluorhydrique HF) .

## Revendications

1. Procédé de gravure d'une surface principale (1a) d'un substrat (1) comprenant une couche mince (11) superficielle, la surface principale (1a) correspondant à la face libre de ladite couche mince (11), le procédé comprenant l'immersion du substrat (1) dans un bain de gravure (100) de manière à exposer la surface principale (1a) à un agent de gravure, le substrat (1) étant orienté vis-à-vis du bain (100) de sorte que :
- lors de son introduction (I) dans le bain (100), la surface principale (1a) soit immergée progressivement d'un point initial d'introduction (PII) à un point final d'introduction (PFI), avec une vitesse d'introduction, et
- lors de sa sortie (S) du bain (100), la surface principale (1a) émerge progressivement d'un point initial de sortie (PIS) à un point final de sortie (PFS), avec une vitesse de sortie,
le procédé étant **caractérisé en ce que** :
- la vitesse d'introduction est choisie de manière à graver la surface principale (1a) selon un premier profil non uniforme entre le point initial d'introduction (PII) et le point final d'introduction (PFI), et/ou
- la vitesse de sortie est choisie de manière à graver la surface principale (1a) selon un deuxième profil non uniforme entre le point initial de sortie (PIS) et le point final de sortie (PFS),
pour compenser des non-uniformités d'épaisseur de la couche mince (11).

2. Procédé de gravure selon la revendication précédente, dans lequel :
- le premier profil de gravure définit une variation d'épaisseur gravée sur la surface principale (1a), entre le point initial d'introduction (PII) et le point final d'introduction (PFI), supérieure ou égale à 0,15 nm, voire supérieure ou égale 0,2 nm, et/ou
- le deuxième profil de gravure définit une variation d'épaisseur gravée sur la surface principale (1a), entre le point initial de sortie (PIS) et le point final de sortie (PFS), supérieure ou égale à 0,15 nm, voire supérieure ou égale à 0,2 nm.

3. Procédé de gravure selon l'une des revendications précédentes, dans lequel le point initial d'introduction (PII) correspond au point final de sortie (PFS), et le point final d'introduction (PFI) correspond au point initial de sortie (PIS).

4. Procédé de gravure selon l'une des revendications précédentes, dans lequel la vitesse d'introduction et/ou la vitesse de sortie est(sont) comprise(s) entre 25cm/s et 0,1cm/s, préférentiellement entre 10cm/s et 0,5cm/s.

5. Procédé de gravure selon l'une des revendications précédentes, dans lequel la vitesse d'introduction et/ou la vitesse de sortie est(sont) non constante(s) respectivement lors de l'introduction dans le bain (100) et de la sortie hors du bain (100), du substrat (1).

6. Procédé de gravure selon l'une des revendications précédentes, dans lequel le bain (100) de gravure contient une solution SC1 (« standard clean 1 »), présentant les proportions 1/2/20 respectivement pour l'ammoniac, le peroxyde d'hydrogène et l'eau déionisée.

7. Procédé de gravure selon l'une des revendications précédentes, dans lequel le substrat (1) est un substrat SOI dont la couche mince (11) superficielle présente une épaisseur inférieure à 50nm et est disposée sur une couche isolante (30), laquelle est disposée sur un substrat support (20) en silicium.

8. Procédé de gravure selon l'une des deux revendications précédentes, dans lequel la couche mince (11) est en silicium monocristallin.

## Patentansprüche

1. Verfahren zum Ätzen einer Hauptoberfläche (1a) eines Substrats (1), umfassend eine dünne Oberflächenschicht (11), wobei die Hauptoberfläche (1a) der freien Fläche der dünnen Schicht (11) entspricht, das Verfahren umfassend das Eintauchen des Substrats (1) in ein Ätzbad (100), um die Hauptoberfläche (1a) einem Ätzmittel auszusetzen, wobei das Substrat (1) gegenüber des Bads (100) so ausgerichtet ist, dass:
- bei ihrer Einführung (I) in das Bad (100), die Hauptoberfläche (1a) allmählich von einem Einführanfangspunkt (PII) zu einem Einführendpunkt (PFI) mit einer Einführgeschwindigkeit eingetaucht wird, und
- während ihrem Austritt (S) aus dem Bad (100), die Hauptoberfläche (1a) allmählich von einem Austrittsanfangspunkt (PIS) zu einem Austrittsendpunkt (PFS) mit einer Austrittsgeschwindigkeit auftaucht,
wobei das Verfahren **dadurch gekennzeichnet ist, dass:**
- die Einführgeschwindigkeit so gewählt ist, dass die Hauptfläche (1a) gemäß einem ersten nicht gleichmäßigen Profil zwischen dem Einführanfangspunkt (PII) und dem Einführendpunkt (PFI) geätzt wird, und/oder
- die Austrittsgeschwindigkeit so gewählt ist, dass die Hauptoberfläche (1a) gemäß einem zweiten nicht gleichmäßigen Profil zwischen dem Austrittsanfangspunkt (PIS) und dem Austrittsendpunkt (PFS) geätzt wird,
zum Kompensieren der Ungleichmäßigkeiten der Dicke der dünnen Schicht (11).

2. Ätzverfahren nach dem vorstehenden Anspruch, wobei:
- das erste Ätzprofil eine Variation einer gravierten Dicke auf der Hauptoberfläche (1a) zwischen dem Einführanfangspunkt (PII) und dem Einführendpunkt (PFI) definiert, die größer als oder gleich 0,15 nm, sogar größer als oder gleich 0,2 nm ist, und/oder
- das zweite Ätzprofil eine Variation der gravierten Dicke auf der Hauptoberfläche (1a) zwischen dem Austrittsanfangspunkt (PIS) und dem Austrittsendpunkt (PFS) definiert, die größer als oder gleich 0,15 nm, sogar größer als oder gleich 0,2 nm ist.

3. Ätzverfahren nach einem der vorstehenden Ansprüche, wobei der Einführanfangspunkt (PII) dem Austrittsendpunkt (PFS) entspricht und der Einführendpunkt (PFI) dem Austrittsanfangspunkt (PIS) entspricht.

4. Ätzverfahren nach einem der vorstehenden Ansprüche, wobei die Einführgeschwindigkeit und/oder die Austrittsgeschwindigkeit zwischen 25 cm/s und 0,1 cm/s, vorzugsweise zwischen 10 cm/s und 0,5 cm/s liegt/liegen.

5. Ätzverfahren nach einem der vorstehenden Ansprüche, wobei die Einführgeschwindigkeit und/oder die Austrittsgeschwindigkeit bei dem Einführen in das Bad (100) und dem Austritt aus dem Bad (100) des Substrats (1) nicht konstant ist/sind.

6. Ätzverfahren nach einem der vorstehenden Ansprüche, wobei das Ätzbad (100) eine SC1-Lösung ("Standard Clean 1") enthält, die die Anteile 1/2/20 jeweils für Ammoniak, Wasserstoffperoxid und entionisiertes Wasser aufweist.

7. Ätzverfahren nach einem der vorstehenden Ansprüche, wobei das Substrat (1) ein SOI-Substrat ist, dessen dünne Oberflächenschicht (11) eine Dicke von weniger als 50 nm aufweist und auf einer Isolierschicht (30) angeordnet ist, die auf einem Trägersubstrat (20) aus Silicium angeordnet ist.

8. Ätzverfahren nach einem der zwei vorstehenden Ansprüche, wobei die dünne Schicht (11) aus monokristallinem Silicium besteht.

## Claims

1. A method for etching a main surface (1a) of a substrate (1) comprising a thin surface layer (11), the main surface (1a) corresponding to the free face of said thin layer (11), the method comprising immersing the substrate (1) in an etching bath (100) so as to expose the main surface (1a) to an etching agent, the substrate (1) being oriented with respect to the bath (100) such that:
- during its introduction (I) into the bath (100), the main surface (1a) is gradually immersed from an initial introduction point (PII) to a final introduction point (PFI), at an introduction speed, and
- during its removal (S) from the bath (100), the main surface (1a) gradually emerges from an initial removal point (PIS) to a final removal point (PFS), at a removal speed,
the method being **characterized in that**:
- the introduction speed is selected so as to etch the main surface (1a) according to a first non-uniform profile between the initial introduction point (PII) and the final introduction point (PFI), and/or
- the removal speed is selected so as to etch the main surface (1a) according to a second non-uniform profile between the initial removal point (Pls) and the final removal point (PFS),
in order to compensate for non-uniformities in the thickness of the thin layer (11).

2. The etching method according to the preceding claim, wherein:
- the first etching profile defines a variation in thickness etched over the main surface (1a), between the initial introduction point (PII) and the final introduction point (PFI), that is greater than or equal to 0.15 nm, or even greater than or equal to 0.2 nm, and/or
- the second etching profile defines a variation in thickness etched over the main surface (1a), between the initial removal point (PIS) and the final removal point (PFS), that is greater than or equal to 0.15 nm, or even greater than or equal to 0.2 nm.

3. The etching method according to either of the preceding claims, wherein the initial introduction point (PII) corresponds to the final removal point (PFS), and the final introduction point (PFI) corresponds to the initial removal point (PIS).

4. The etching method according to any of the preceding claims, wherein the introduction speed and/or the removal speed is/are between 25 cm/s and 0.1 cm/s, preferably between 10 cm/s and 0.5 cm/s.

5. The etching method according to any of the preceding claims, wherein the introduction speed and/or the removal speed is/are not constant during the introduction into the bath (100) and the removal from the bath (100), respectively, of the substrate (1).

6. The etching method according to any of the preceding claims, wherein the etching bath (100) contains an SC1 ("standard clean 1") solution having ammonia, hydrogen peroxide and deionized water in proportions of 1/2/20, respectively.

7. The etching method according to any of the preceding claims, wherein the substrate (1) is an SOI substrate, the thin surface layer (11) of which has a thickness less than 50 nm and is arranged on an insulating layer (30) arranged on a support substrate (20) made of silicon.

8. The etching method according to either of the two preceding claims, wherein the thin layer (11) is made of monocrystalline silicon.
